(19) **Europäisches Patentamt / European Patent Office / Office européen des brevets**

(11) **EP 1 212 777 B1**

(12) **EUROPEAN PATENT SPECIFICATION**

(45) Date of publication and mention
of the grant of the patent:
**30.05.2007 Bulletin 2007/22**

(51) Int Cl.:
*H01J 37/304* (2006.01)  *H01J 27/02* (2006.01)
*H01J 27/16* (2006.01)  *H01J 27/18* (2006.01)

(21) Application number: **00962690.4**

(22) Date of filing: **18.09.2000**

(86) International application number:
**PCT/GB2000/003577**

(87) International publication number:
**WO 2001/022470 (29.03.2001 Gazette 2001/13)**

(54) **ION BEAM VACUUM SPUTTERING APPARATUS AND METHOD**

VORRICHTUNG UND VERFAHREN ZUM VAKUUM-IONENSTRAHLSPUTTERN

APPAREIL ET PROCEDE DE PULVERISATION A VIDE PAR FAISCEAU IONIQUE

(84) Designated Contracting States:
**AT BE CH CY DE DK ES FI FR GB GR IE IT LI LU MC NL PT SE**

(30) Priority: **17.09.1999 GB 9922110**

(43) Date of publication of application:
**12.06.2002 Bulletin 2002/24**

(73) Proprietor: **Nordiko Technical Services Limited**
**North Street**
**Havant**
**Hampshire, PO9 1QU (GB)**

(72) Inventors:
• **DAVIS, Mervyn, Howard**
**Chichester**
**West Sussex PO20 7HB (GB)**
• **PROUDFOOT, Gary**
**Fremont, CA 94538 (US)**

• **PEARSON, David, Ian, Charles**
**Hayling Island PO11 0HP (GB)**

(74) Representative: **Smaggasgale, Gillian Helen et al**
**W.P. Thompson & Co,**
**55 Drury Lane**
**London WC2B 5SQ (GB)**

(56) References cited:
**WO-A-98/18150**          **US-A- 5 296 122**

• **JOLLY T W ET AL: "MICROWAVE BEAM SOURCES FOR REACTIVE ETCHING AND SPUTTER DEPOSITION APPLICATIONS" REVIEW OF SCIENTIFIC INSTRUMENTS, US, AMERICAN INSTITUTE OF PHYSICS. NEW YORK, vol. 61, no. 1, PART 02, 1990, pages 297-299, XP000101496 ISSN: 0034-6748**

**Description**

FIELD OF THE INVENTION

This invention relates to a novel ion beam vacuum sputtering apparatus for deposition of thin films of sputtered material upon a substrate and to a novel method of effecting ion beam vacuum sputtering.

DESCRIPTION OF THE PRIOR ART

Vacuum sputtering is a well established method for deposition of thin films of sputtered material upon a substrate. According to this technique a beam of ions is fired at a target in a vacuum chamber which is typically maintained at a pressure in the range of from about $10^{-5}$ millibar (about $10^{-4}$ Pa) to about $10^{-3}$ millibar (about $10^{-2}$ Pa). The resulting impact of the ions against the target causes atoms of the target material to be ejected therefrom and to deposit upon the surface of a substrate, such as a silicon wafer, or a ceramic, metal or glass substrate, positioned in the path of the sputtered atoms.

Premium applications in thin film deposition require special attention to the control of repeatability of deposited film thickness. This is a key issue in the deposition of very thin films. Presently the magnetic recording industry requires the reproducible deposition of ultra thin films which may have a thickness as low as about 0.5 nm. For premium optical applications required in the fabrication of low loss laser mirrors, and dense wavelength division multiplexers (DWDMs), deposition of multi-layer structures is required and precision within the multi-layer structures is essential in attaining the required performance.

Thin film deposition equipment is traditionally controlled by control of time and power. This approach assumes that time dependent variations within the process average out so as to nullify any overall effects. Both for ultra thin films and multilayer complex optical structures this approach is inadequate.

Shutters are often used to start and stop the deposition of thin films. However, these devices tend to act in a somewhat arbitrary manner and lead to unsatisfactory results. Thus the traverse of the shutter can destroy the film thickness uniformity of ultra thin films, and the repeatability within thicker complex multi-layer structures.

In vacuum sputtering it is desirable to control the material deposition flux. This is normally dependent upon the stability of a number of key parameters within the system. While time can normally be accurately monitored and measured, the delivered power stability is limited to typically the order of about 1%. The desired repeatability for thin film applications can be perhaps ten times smaller than the limit dictated by the power supply stability.

Broad ion beam deposition (BIBD), is an increasingly used technique to deposit premium quality thin films. A range of BIBD systems is commercially available from Nordiko Limited of Hayward Business Centre, New Lane, Havant, Hampshire PO9 2NL for the deposition of ultra thin films and for building complex multi-layers. These BIBD systems utilise a unique form of r.f. excited broad beam ion source, which is further described in International Patent Publication No. WO 98/18150. This ion beam source is an efficient device which typically yields about 1 mA of current output for each r.f. watt of input power. However, since a typical current output used lies in the region of from about 200 to about 500 mA, a 1% variation in delivered r.f. power can result in a less than desirable variation in current and ultimately the deposition flux.

Although the control of thickness in ultra thin films has different requirements from that required in thicker complex multi-layer film stacks, common approaches to precision control apply. In broad ion beam deposition (BIBD) the substrates receiving deposition are normally mounted on a substrate table which is rotated with respect to the deposition flux so that the substrate is rotated in the plane of the surface upon which deposition is taking place. For ultra thin films the deposition time is short, for the multi-layers it can be very long. The same approach to improve precision can yield dramatic improvements in the reproducibility of both tasks.

In both instances there is an advantage in ensuring that the substrate table completes an integral number of revolutions during the deposition cycle. Rather than operating on time and power, calibration runs are performed so that a deposition rate can be attained that, when applied for an integral number of table rotations, it will provide the desired film thickness.

When using broad ion beam deposition (BIBD) an electrostatic shuttering technique can be used. The sequence is as follows:

1. The substrate or substrates is or are loaded and any pre-clean procedure is run.
2. The mechanical substrate shutter is closed.
3. The deposition ion source will normally be in an idle mode, i.e. the discharge is on but an energetic ion beam is not extracted.
4. The extraction grids of the ion gun are turned on and the required parameters for the beam are established and verified.

5. The extraction voltages are turned off.

6. The mechanical substrate shutter is opened.

7. The extraction voltages are turned on, thereby effectively opening an electrostatic shutter, and the deposition time is thereby started, this event being synchronised with the table rotation.

8. Following the predetermined number of table rotations the extraction voltage is turned off, terminating the deposition and effectively closing the electrostatic shutter.

9. The mechanical shutter is then closed.

This technique provides reasonably good control over reproducibility. It does not, however, address the potential variability in the rate of delivery of material flux.

BRIEF SUMMARY OF THE INVENTION

There is accordingly a need to provide a novel method of effecting vacuum sputtering which enables the deposition of thin films in single or multi-layer structures with great accuracy and with reliable repeatability.

There is a further need to provide a novel sputtering apparatus which can be used to produce sputtered coatings on substrates, whether as single films or as part of multi-layer structures, with great reliability and great precision of film thickness even down to film thicknesses of about 0.5 nm.

It is accordingly an object of the invention to provide a novel sputtering method and apparatus which will substantially satisfy these needs.

The invention further seeks to provide a novel sputtering apparatus which enables significantly improved control of the material deposition flux compared with prior art devices.

It is a further objective of the invention to provide a novel method of effecting vacuum sputtering whereby accurate automatic control of the material deposition flux can be achieved in a simple manner.

According to the present invention there is provided

a vacuum sputtering apparatus for depositing a thin film of sputtered material on a substrate, the apparatus comprising:

> a vacuum chamber for containing:

>> a target from which material is to be sputtered; and
>> a substrate upon which material from the target is to be deposited;

> an ion gun for projecting a beam of ions towards the target, the ion gun including:

>> a plasma generation chamber for generation of a plasma therein;
>> gas admission means for admission to the plasma generation chamber of a gas from which the plasma is to be generated;
>> r.f. coil means for supplying r.f. power to gas in the plasma generation chamber for generation of a plasma therefrom;
>> magnet means for trapping adjacent the wall of the plasma generation chamber electrons released as a result of plasma formation in the plasma generation chamber; and
>> extraction means for extracting ions from the plasma in the plasma generation chamber and for accelerating the extracted ions in a beam arranged to impinge upon the target, the extraction means including an accelerator grid;

> r.f. power supply means for supplying r.f. power to the r.f. coil;
> d.c. voltage supply means for supplying a d.c. voltage to the accelerator grid to cause extraction of ions from the plasma generation chamber and acceleration thereof in a beam towards the target;
> control signal generator means for deriving from the current flowing from the d.c. voltage supply means to the accelerator grid a control signal; and
> a host computer system which is arranged to be supplied with the control signal, to perform current/time integration and to control the operation of the r.f. power supply means
> the control signal generator means comprising:

>> resistance means connected in series between the d.c. voltage supply and the accelerator grid; and

differential amplifier means whose input is connected across the resistance means and whose output provides a control signal which is representative of the current flowing between the d.c. voltage supply and the accelerator grid.

The invention further provides a method of effecting vacuum sputtering of a material from a target onto a substrate in a vacuum chamber so as to deposit a thin film of sputtered material on the substrate, which method comprises:

providing an ion gun for projecting a beam of ions towards the target, the ion gun including:

a plasma generation chamber for generation of a plasma therein;
gas admission means for admission to the plasma generation chamber of a gas from which the plasma is to be generated;
r.f. coil means for supplying r.f. power to gas in the plasma generation chamber for generation of a plasma therefrom;
magnet means for trapping adjacent to the wall of the plasma generation chamber electrons released as a result of plasma formation in the plasma generation chamber; and
extraction means for extracting ions from the plasma in the plasma generation chamber and for accelerating the extracted ions in a beam arranged to impinge upon the target, the extraction means including an accelerator grid;
supplying r.f. power to the r.f. coil from an r.f. power supply means;
supplying a d.c. voltage from a d.c. voltage supply means to the accelerator grid to cause extraction of ions from the plasma generation chamber and acceleration thereof in a beam towards the target;
deriving from the current flowing from the d.c. voltage supply means to the accelerator grid a control signal;
supplying the control signal to a host computer system which is arranged to perform current/time integration and to control the operation of the r.f. power supply means;
generating the control signal by means of a resistance means connected in series between the d.c. voltage supply and the accelerator grid and a differential amplifier means whose input is connected across the resistance means and whose output provides a control signal which is representative of the current flowing between the d.c. voltage supply and the accelerator grid.

BRIEF DESCRIPTION OF THE DRAWINGS

Figure 1 is a diagram of a vacuum sputtering apparatus embodying the present invention; and
Figures 2 to 6 are circuit diagrams of different forms of control circuit for controlling the operation of the vacuum sputtering apparatus of Figure 1.

DETAILED DESCRIPTION OF THE PREFERRED EMBODIMENTS

The present invention provides a vacuum sputtering apparatus for depositing a thin film of sputtered material on a substrate. This apparatus comprises a vacuum chamber for containing a target from which material is to be sputtered and a substrate upon which material from the target is to be deposited. The vacuum chamber also contains an ion gun for projecting a beam of ions towards the target. The ion gun includes (i) a plasma generation chamber for generation of a plasma therein, (ii) gas admission means for admission to the plasma generation chamber of a gas from which the plasma is to be generated, (iii) r.f. coil means for supplying r.f. power to gas in the plasma generation chamber for generation of a plasma therefrom, (iv) magnet means for trapping adjacent to the wall of the plasma generation chamber electrons released as a result of plasma formation in the plasma generation chamber, and (v) extraction means for extracting ions from the plasma in the plasma generation chamber and for accelerating the extracted ions in a beam arranged to impinge upon the target. The extraction means includes an accelerator grid. The apparatus also includes r.f. power supply means for supplying r.f. power to the r.f. coil, and d.c. voltage supply means for supplying a d.c. voltage to the accelerator grid to cause extraction of ions from the plasma generation chamber and acceleration thereof in a beam towards the target. It also comprises means for deriving from the current flowing from the d.c. voltage supply means to the accelerator grid a control signal for controlling the r.f. power supply means.

The method of the invention involves effecting vacuum sputtering of a material from a target onto a substrate in a vacuum chamber so as to deposit a thin film of sputtered material on the substrate. Such a method comprises providing an ion gun of the type described in the preceding paragraph for projecting a beam of ions towards the target. In the method of the invention r.f. power is supplied to the r.f. coil from an r.f. power supply means, while a d.c. voltage is supplied from a d.c. voltage supply means to the accelerator grid to cause extraction of ions from the plasma generation chamber and acceleration thereof in a beam towards the target. There is derived from the current flowing from the d.c. voltage supply means to the accelerator grid a control signal for controlling the r.f. power supply means such that the accelerator current is held at a desired level.

The control signal generator means comprises resistance means connected in series between the d.c. voltage supply and the accelerator grid and differential amplifier means whose input is connected across the resistance means and whose output provides a control signal which is representative of the current flowing between the d.c. voltage supply and the accelerator grid. This control signal is supplied to a host computer system which is arranged to perform current/ time integration and to control the operation of the r.f. power supply means. Alternatively the control signal may be supplied to the r.f. power supply means for direct closed loop accelerator grid current control and stabilisation.

In an alternative preferred embodiment the control signal generator means comprises resistance means connected in series between the d.c. voltage supply and the accelerator grid, differential amplifier means whose input is connected across the resistance means and whose output provides a control signal which is representative of the current flowing between the d.c. voltage supply and the accelerator grid, voltage divider means for providing a voltage signal whose voltage is intermediate between the voltage of the d.c. voltage supply and earth potential, amplifier means for conditioning and amplifying the voltage signal from the voltage divider means whose output provides a signal representative of the accelerator grid voltage, and multiplier integrated circuit means which receives as inputs the outputs from the differential amplifier means and from the amplifier means and whose output provides a control signal which is representative of the power supplied to the accelerator grid. In such an apparatus the control signal can be supplied to a host computer system which is arranged to perform accelerator grid power/time integration and to control the operation of the r.f. power supply means. Alternatively the control signal can be supplied to the r.f. power supply means for direct closed loop accelerator grid power control.

In one form of vacuum sputtering apparatus according to the invention the control signal generator means further comprises:

second resistance means connected in series between a second d.c. voltage supply and a second accelerator grid of the ion gun; and

second differential amplifier means whose input is connected across the second resistance means and whose output provides a control signal which is representative of the current flowing between the second d.c. voltage supply and the second accelerator grid and which is also supplied to the host computer system.

A vacuum sputtering apparatus according to the invention preferably further comprises shutter means in the vacuum chamber between the target and the substrate and movable between a first position in which the shutter means shields the substrate from material sputtered from the target and a second position in which it permits material sputtered from the target to reach the substrate, whereby with the shutter means in its first position the parameters for the ion beam can be established and verified, whereafter the d.c. power supply to the accelerator grid can be turned off, and whereby with the shutter means in its second position the d.c. power supply to the accelerator grid can be turned back on again to effect extraction of ions from the plasma generation chamber to form an ion beam and to cause material to be sputtered from the target and to be deposited upon the substrate.

Preferably a surface of the target is so positioned in the vacuum chamber of the apparatus of the invention that the ion beam impinges upon it at an oblique angle whereby material ejected from the target travels along a path which is directed away from that of the ion beam. Thus it is preferred that the ion beam strikes the target at an angle to its surface of from about 30° to about 60°, for example about 45°.

The substrate is preferably so positioned that material ejected from the target strikes it an angle which is normal to the surface of the substrate or at an angle which is oblique to the surface of the substrate. Such an oblique angle can correspond to an angle to the direction normal to the surface of the substrate of up to about 50°, for example an angle of from about 30° to about 45° to the direction normal to the surface of the substrate. The orientation of the substrate relative to the path of material sputtered from the target can be selected so as to optimise the uniformity of deposited material or to optimise the directionality of deposition.

Normally the substrate is mounted upon a substrate table, which is typically arranged so as to be rotatable. The table is preferably rotatable at up to many hundred rpm, e.g. up to about 1000 rpm or higher. In many cases, however, it will suffice for the table to be rotatable at a speed of up to about 30 rpm, eg from about 5 rpm up to about 20 rpm.

In the practice of the invention it is proposed to address the need for greater precision by utilising the concept of ion current integration. In broad beam ion deposition (BIBD) there is a glow discharge generation system that produces an abundance of positive ions within a semi-closed volume. On one side of this volume is a perforated structure comprising a number of apertures within an ion accelerator. The current output of the source is dependent upon the concentration of ions generated in the glow discharge and the voltages applied to the extraction system. The voltage applied from the extraction bias supplies from the switched mode d.c. power supplies is very stable. However, the power delivered from the solid state r.f. power supplies is less stable and it is the resulting variation in power input that caused problems in the prior art systems. As the power from the r.f. power supply varies, so the current output from the ion source, and hence the ion flux, also varies; this in turn leads to variability in the sputtered material flux.

In the method of the invention, rather than operating for a predetermined number of revolutions at a given ion beam current, the required current and the predicted deposition time are determined and then the current is integrated during the deposition enabling the total number of delivered coulombs of ions to be tracked.

For manufacture of complex thick multi-layer films, when the desired integrated current is reached, the deposition can be terminated upon completion of the next integral revolution of the substrate table.

For ultra thin films the ion current integration can be monitored and an algorithm continuously used to adjust the current to ensure that the correct current dose is delivered at the completion of the desired number of integral table revolutions.

Accurate "real-time" measurement of ion source beam current levels is critical for a highly stable and repeatable ion beam process. The concept behind the preferred embodiments of the invention which are further described below is to measure differentially the current levels in the ion source accelerator grid circuit, and perform one of the following:

(a) Retransmit these current levels to a host computer controller, which then performs fast current/time integration, the result of which provides the total "dose" that a particular substrate or target has received, in coulombs.
(b) Use the signal from the current monitor to "close" an accelerator beam current control loop, which permits the apparatus to demand, and maintain a constant beam current level, by feedback adjustment of r.f. power levels. This principle of operation also ensures a constant "dose" rate, in coulombs, at the substrate or target. The constant accelerator beam current is controlled at a known beam energy level.

By adding a voltage sense circuit to the current monitor, and performing voltage and current multiplication, it is possible to control beam power (at a fixed energy level). The advantage of direct measurement of accelerator grid current and voltage levels is that the circuit is instantaneously measuring and controlling the accelerator grid levels, at speeds unattainable by computer/sampling techniques.

The accelerator grid current is preferably differentially measured in the ground line (i.e. in the coaxial cable screen), thereby eliminating the need for high side measuring equipment. This also has the advantage of lower superimposed r.f. ripple levels, and substantially reduced cost. Differential measurement ensures that "common mode" noise effects are rejected, ensuring high signal integrity.

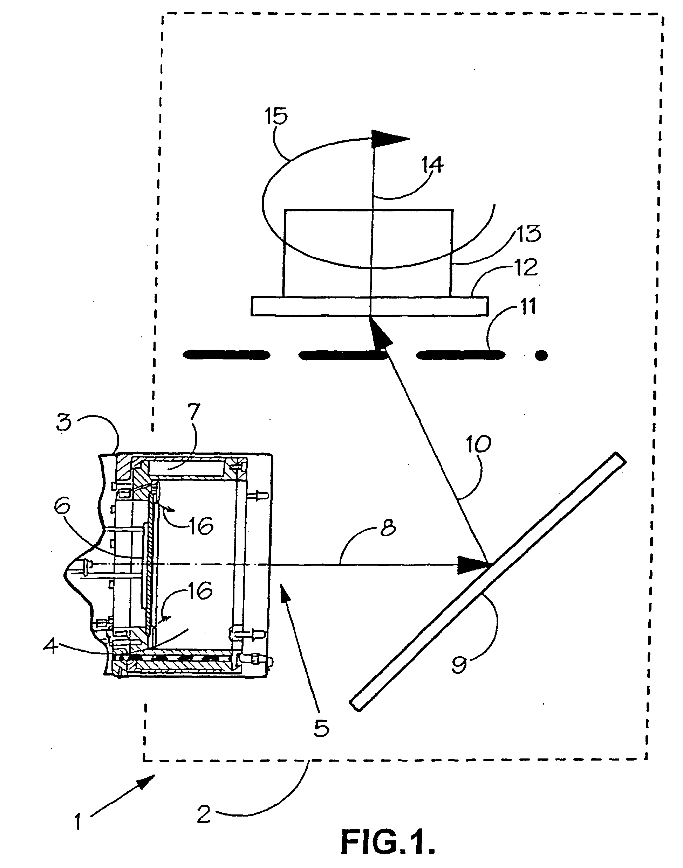

Referring to Figure 1, a vacuum sputtering apparatus 1 comprises a vacuum chamber which is indicated generally in broken lines by reference numeral 2. Vacuum chamber 2 is provided with a conventional high vacuum pump (not shown) by means of which vacuum chamber 2 can be evacuated to a low pressure suitable for effecting vacuum sputtering. Typically the pressure within vacuum chamber 2 in use is in the range of from about $10^{-5}$ millibar (about $10^{-4}$ Pa) to about $10^{-3}$ millibar (about $10^{-2}$ Pa).

Mounted in vacuum chamber 2 is an ion gun 3, which is of the general type disclosed in International Patent Publication No. WO 98/18150, the entire contents of which are incorporated herein by reference. Ion gun 3 includes a plasma generation chamber 4, a composite grid structure 5, a substantially flat r.f. induction coil 6, and a plurality of primary bar magnets 7 arranged around the periphery of plasma generation chamber 4 for trapping electrons adjacent the wall of plasma generation chamber 4. Composite grid structure 5 has at least two grids. Thus it may include, as described in International Patent Publication No. WO 98/18150, first, second and third multi-apertured grids positioned in close proximity to one another. The first grid is in this case connected to a first positive potential source and contacts the plasma in the plasma generation chamber 2 in use of the vacuum sputtering apparatus 1. Its potential is less than that of the plasma and accordingly acts as an accelerator grid to cause extraction of ions from the plasma generation chamber and acceleration thereof in a beam towards the target. The second grid, which is next to the first grid, is connected in use of the vacuum sputtering apparatus 1 to a second potential source of lower potential than the first positive potential source. Its function is to produce a first acceleration field for further accelerating ions from the plasma in the plasma generation chamber 4 through the first grid towards and through the second grid. The third grid is mounted next to the second grid, on the opposite side thereof from the first grid, and is connected, in use of the apparatus 1, to ground so as to produce a second retarding field forming an electrostatic beamlet collimation system and also preventing electrons from streaming back into plasma generation chamber 2. The apertures in the three grids of composite grid structure 5 are aligned one with another so that ions emerging from an aperture in the first grid can be accelerated through a corresponding aperture in the second grid and then pass through a corresponding aperture in the third grid to form a beamlet. The resulting plurality of beamlets from the third grid form an ion beam downstream from the third grid. This ion beam is represented diagrammatically in Figure 1 by arrow 8 and is arranged to impinge, in use of apparatus 1, on a target 9.

In use of apparatus 1 in sputtering mode, the first grid typically has a positive potential in the range of from about +500 V to about +2000 V, for example about +1000 V, applied to it, while the second grid has a negative potential in the range of from about -150 V to about -1000 V, for example about -850 V, applied to it, and the third grid is at ground potential.

The impact of ions in ion beam 8 upon target 9 causes atoms to be ejected from target 9 as indicated by arrow 10. A mechanical shutter 11 of conventional type is disposed in the path of atoms sputtered from target 9. When shutter 11 is open the sputtered atoms are deposited as a sputtered layer upon substrate 12.

However, when shutter 11 is closed, the sputtered atoms are prevented from reaching substrate 12.

Substrate 12 is mounted on substrate table 13 which is arranged so as to be rotatable about axis 14 as indicated by arrow 15. Typically substrate table 13 can be rotated at a speed of up to about 30 rpm or more, for example up to many hundred rpm, e.g. 200 rpm.

Gas for generation of the plasma in plasma generation chamber 4 can be bled in via a suitable inlet, as described in International Patent Publication No. WO 98/18150, as indicated by arrows 16. Suitable gases for this purpose include Ar, Kr, Xe, $O_2$, $CO_2$, $N_2$, $CH_4$, $C_2H_6$, $C_3H_8$, $Cl_2$, $SF_6$, $C_2F_6$, or a $C_2F_6$/$CHF_3$ mixture. Alternatively a volatile hydrocarbon can be bled in via the inlet.

For further details regarding the construction and operation of ion gun 2, the attention of the reader is directed to International Patent Publication No. WO 98/18150.

Although relatively slow rotation speeds of, for example, up to about 30 rpm are adequate for many purposes, in some cases it may be preferred to use higher rotation speeds of, for example, several hundred rpm. Thus for optical applications higher rotation speeds of, for example, about 200 rpm, may be beneficial. At low rotation speeds it is highly desirable that an integral number of revolutions is completed to ensure control of uniformity of deposition of ultra-thin films. However, for relatively thick films, the key issues are repeatability and optical design integrity.

In this case many revolutions are completed before interruption of deposition and it becomes more important to integrate the flux. In this instance, if the rate of rotation of the table is relatively slow, to delay the flux interruption until the completion of the current rotation when the requisite dose has been delivered can perturb the required film thickness repeatability. Accordingly it can be beneficial to use much higher rotational speeds, for example about 600 to about 800 rpm, and then either to terminate the deposition immediately or, alternatively, to complete the current revolution prior to termination; the table rotational speed is high enough in this case not to have a deleterious effect upon the repeatability.

If the substrate 12 is a non-conductor, then a plasma neutraliser (not shown) similar to plasma neutraliser 7 of Figure 1 of International Patent Publication No. WO 98/18150 should be mounted in vacuum chamber 2 to prevent a charge building up on substrate 12.

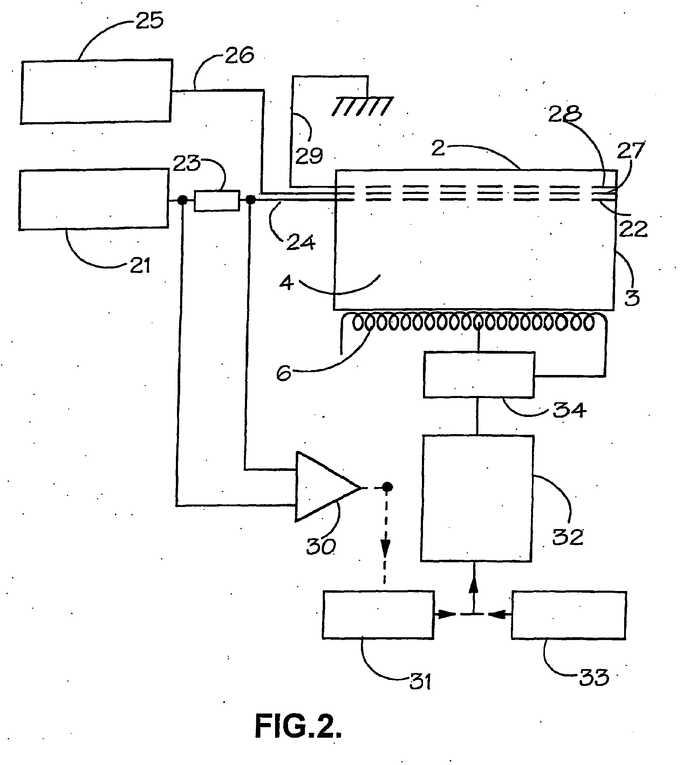

Figure 2 is a circuit diagram of the control circuit used for controlling the sputtering apparatus 1 of Figure 1. This circuit is designed to measure differentially the current levels in the ion source accelerator grid. The ion source has two additional grids beyond the accelerator grid.

A voltage supply 21 provides a constant positive d.c. potential for applying a bias potential to the accelerator grid 22 of the ion gun 3 of the sputtering apparatus 1 of Figure 1, that is to say the grid in contact with the plasma in the plasma generation chamber 4. A high precision/high stability resistor 23 is placed in series with the screen of the coaxial d.c. accelerator grid cable 24. A second d.c. voltage supply 25 is connected by a coaxial cable 26 to a second accelerator grid 27. The third grid 28 is connected by a cable 29 to earth. The current flow to the accelerator grid 22 develops a voltage drop across resistor 23. The voltage generated across resistor 23 is differentially amplified by amplifier 30. The scaled voltage output of amplifier 30, which represents accelerator grid current, i.e. the current flowing between voltage supply 21 and accelerator grid 22, is fed into a host computer control system 31 for accelerator grid current control. Host computer control system 31 controls an r.f. power supply unit 32 and also controls the accelerator grid current at a set point value, for which purpose it is provided with an accelerator grid current control set point as indicated by reference numeral 33. Host computer control system 31 is connected via an r.f. matching unit 34 to r.f. power coil 6 of ion gun 3. Typically r.f. power supply unit 34 is arranged to produce a commercially acceptable high radio frequency, such as 13.65 MHZ or a multiple thereof.

Host computer control system 31 is also arranged to perform fast current/time integration and thus determine the number of coulombs that have passed from voltage supply 21 to accelerator grid 22.

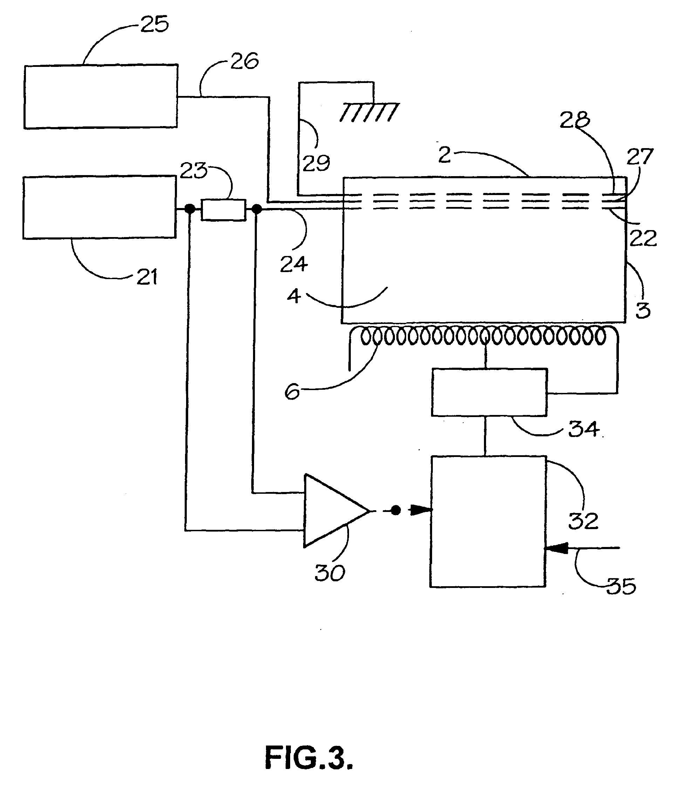

The circuit diagram of Figure 3 is similar to that of Figure 2 except that the scaled voltage output of amplifier 30 is fed directly into r.f. power supply unit 32 for direct closed loop accelerator grid current control. Reference numeral 35 indicates an accelerator grid current control set point.

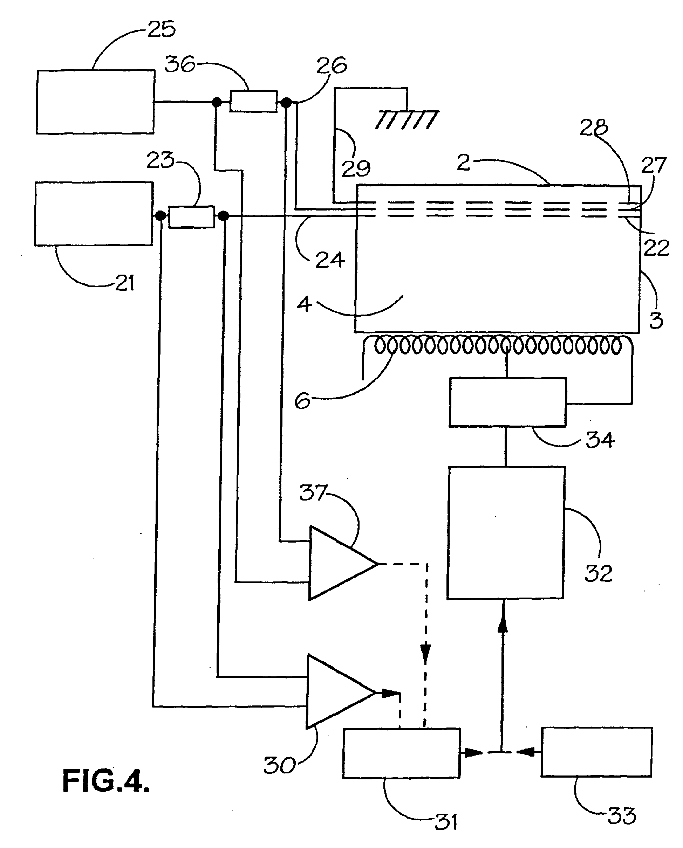

Figure 4 shows a third possible circuit diagram in which like reference numerals indicate like parts to those of Figures 2 and 3. In addition to connecting resistor 23 in series with the screen of the coaxial d.c. accelerator grid cable 24, a further high precision/high stability resistor 36 is placed in series with the screen of the coaxial cable 26 for the second accelerator grid 27. The voltage generated across resistor 36 is differentially amplified by amplifier 37. The outputs of amplifiers 30 and 37 are fed into the host computer system 31 which is arranged to perform a calculation of a function of the current $i_1$ flowing in line 24, of the current $i_2$ flowing in line 26, and to integrate this with respect to time t:

$$F = \int f(i_1, i_2)\, dt$$

For example this function may be:

$$F = \int_0^t (i_1 - c * i_2) \, dt$$

where the factor c, which is typically an experimentally determined value in the range 0 to 3, is chosen to allow for loss of beam ions to the second grid 27 and the third grid 28 and to allow for a proportion of current $i_1$ being generated by electron attraction. The factor c generally varies from one ion gun to another and can be determined for a particular ion gun, for example, by choosing a value for c and a given set of sputtering conditions and measuring the deposited thickness $\theta_1$ of material for a given number of coulombs as determined by function F above. Then slightly different sputtering conditions are chosen and the thickness $\theta_2$ of material deposited under those conditions for the same number of coulombs is also measured. If $\theta_1$ and $\theta_2$ are different, then c is adjusted in a logical manner and the experiment is repeated as necessary until $\theta_1$ and $\theta_2$ are substantially the same. If, however, $\theta_1$ and $\theta_2$ are substantially the same, then the selected factor c can be entered into the host computer control system 31.

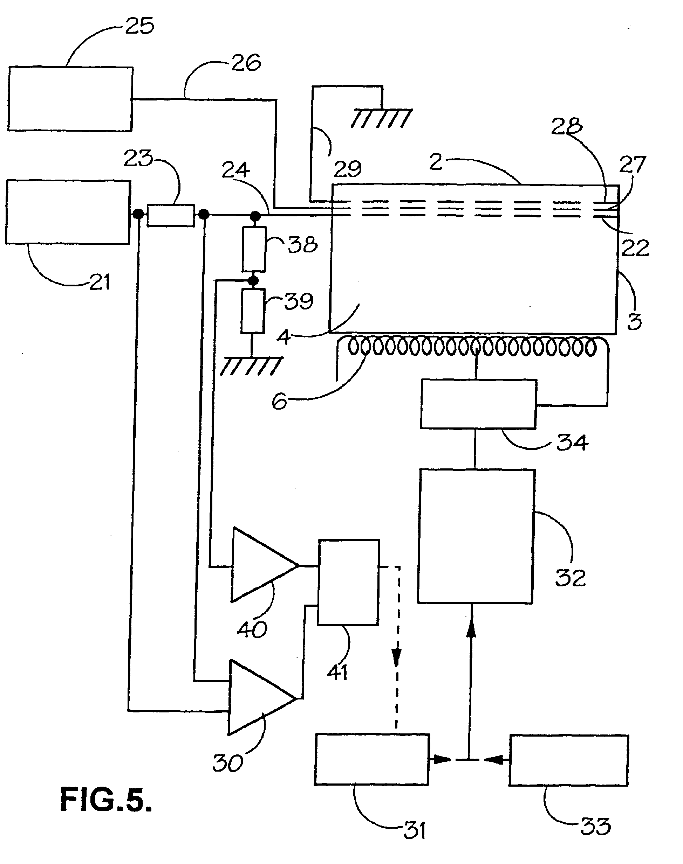

Figure 5 shows a fourth possible circuit diagram in which like reference numerals have been used to indicate like parts to those of Figures 2 to 4. In addition to connecting resistor 23 in series with the screen of the coaxial d.c. accelerator grid cable 24, a potential divider including resistors 38 and 39 taps off a portion of the accelerator grid voltage and the resulting signal is conditioned and amplified by amplifier 40. The outputs from amplifiers 30 and 40 are fed into a multiplier integrated circuit 41 whose output is a scaled proportion of the accelerator beam power. The output from multiplier integrated circuit 41 is then fed to host computer control system 31 which detects the total power transmitted from voltage source 21 to accelerator grid 22 and is arranged to perform accelerator grid power/time integration.

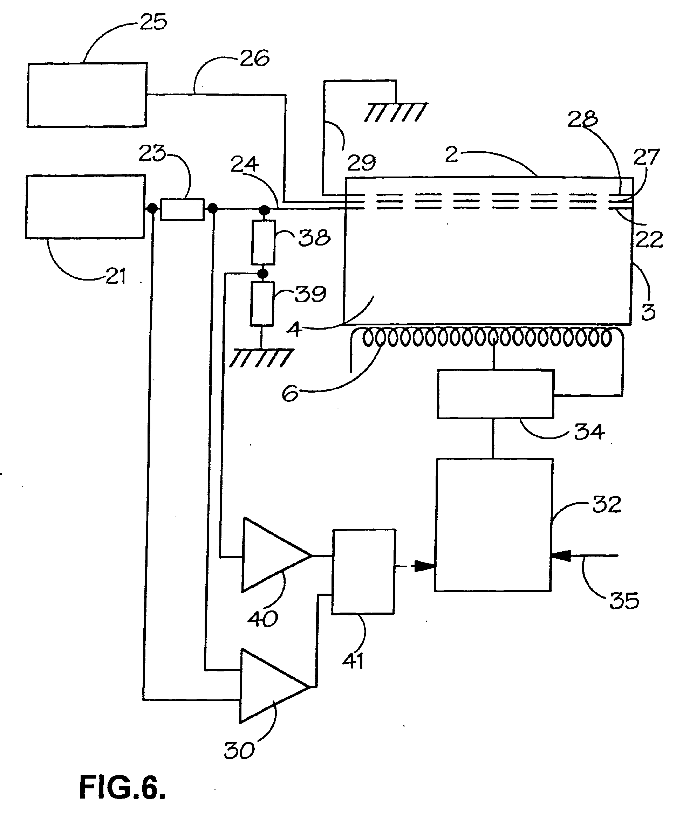

Figure 6 shows a fifth circuit diagram for controlling the vacuum sputtering apparatus of Figure 1. Again, like reference numerals are used to designate like parts in the circuit diagrams of Figures 2 to 5. The output signal from multiplier integrated circuit 41 is fed into the r.f. power supply unit 32 for direct closed loop accelerator grid power control.

In the apparatus of Figure 1 the composite grid structure 5 has been described as having three grids. It is, however, alternatively possible to utilise a composite grid structure that has two grids only or a composite grid structure with four grids.

If there are only two grids, then the first or accelerator grid, which is bathed by the plasma within the plasma generation chamber 2, is typically positively biased in use. The positive potential to which the first grid is biased determines the beam voltage and is typically in the range of from about +500 V to about +2000 V. The second grid, which is on the outer side from the plasma generation chamber 2 from the first grid, is negatively biased, typically to a negative voltage of from about -150 V to about -1000 V.

In the case of a composite grid structure 5 with four grids, then the first accelerator grid, which is bathed by the plasma within the plasma generation chamber 2, is also typically positively biased and the voltage of this grid defines the beam voltage. Typically this grid is biased to a positive potential of from about +500 V to about +2000 V. A second (or first intermediate) grid, which is the next grid outward from the plasma generation chamber 2 after the first grid, is biased negatively, typically to a voltage of from about -150 V to about -1000 V. A third (or second intermediate) grid, which is the next grid outward from the first intermediate grid, is normally also negatively biased, typically at a voltage of from about -50 V to about -500 V. The fourth grid is the furthest away from the plasma generation chamber and is typically held at ground potential. The second (or first intermediate) grid is tuned to provide the desired beam extraction and minimise the grid current to the second grid. The third (or second intermediate) grid is used to tune the beam quality.

If the composite grid structure 5 contains four grids, then an additional signal can be generated which represents the current flowing in the cable connected to the third grid, in a similar manner to that in which a signal is generated for grid 27 in the circuit of Figure 4. This additional signal can also be used as part of a grid power control function or a coulomb integration function in the host computer system 31.

In operation of the vacuum sputtering apparatus, a substrate 12 is mounted on rotatable substrate table 13, or a plurality of substrates 12 are mounted on respective rotatable substrate tables 13, and placed within vacuum chamber 2. If the substrate or substrates 12 is or are nonconducting, then a plasma neutraliser is also provided within vacuum chamber 2. Vacuum chamber 2 is then evacuated to an appropriate sputtering pressure and any necessary precleaning procedure is run. Next the substrate shutter 11 is closed. The ion gun 3 is powered up in idle mode so that a plasma is generated in plasma generation chamber 4 but with the extraction grids, including accelerator grid 22, turned off so that an energetic ion beam is not extracted from the plasma generation chamber 4. The extraction grids, including accelerator grid 22, are then turned on and the required parameters for the ion beam 8 are established and verified. The extraction voltages, including that supplied by voltage source 21 to accelerator grid 22, are then turned off. The shutter 11 is then opened. The extraction voltages, including the voltage supplied to accelerator grid 22, are then turned on and the deposition period is started, this being synchronised with the rotation of substrate table 13. Typically substrate table 13 is rotated at a speed of from about 10 to about 20 rpm. When the control circuit, i.e. whichever one of the control circuits of Figures 2 to 6 is fitted to the vacuum sputtering apparatus 1, detects that sufficient material has been sputtered, then, if this moment coincides with the completion of a revolution of the substrate table 13, the extraction voltages, including the voltage supplied to accelerator grid 22, are turned off so as to halt extraction of the ion beam and hence bombardment of the target. If, however, the substrate table 13 has not completed a revolution at the moment that the control circuit detects that sufficient material has been sputtered, then that revolution is completed before the extraction voltages are turned off.

The apparatus of the invention is preferably arranged to operate under the control of software which permits automatic rotational speed adjustment. Such software is adapted so that the operative can enter via a conventional computer keyboard details of the desired deposition time and a proposed rotational speed for the substrate table 13. The software then calculates an adjusted rotational speed which will provide an integral number of complete revolutions of the substrate table 13. The adjusted rotational rate is calculated according to the algorithm:

$$\text{Adjusted RPM} = \frac{60 \times \text{INT(Requested RPM} \times \text{Deposition Time}/60)}{\text{Deposition Time}}$$

In this algorithm INT(x) returns an integral value of a floating point number.

If, for example, a deposition time of 30 seconds is required and a rotation speed of 15 rpm is entered by the operative via the computer keyboard, then the adjusted rotational speed will be:

$$\text{Adjusted RPM} = \frac{60 \times \text{INT}(15 \times 30/60)}{30} = 14 \text{ rpm}$$

However, it can readily be seen that a value entered of only 12 rpm would not require any adjustment.

On the other hand, if a deposition time of 4 minutes 15 seconds is required and a rotational speed of 10 rpm is entered by the operative using the computer keyboard, then the adjusted rotational speed is given by:

$$\text{Adjusted RPM} = \frac{60 \times \text{INT}(10 \times 255/60)}{255} = 9.88 \text{ rpm}$$

There is an error of only 0.02%.

It is further contemplated that the computer software could be programmed so as to permit a search for adjusted rotational speeds for the substrate table 13 to be made within a range of about 25% from the value entered by the operative which will allow an integral number of substrate table revolutions to be made within the desired deposition parameters. Such a search would have found, for example, that a rotational speed of 12 rpm (rather than 14 rpm) would give an integral number of revolutions for the substrate table 13 for a deposition time of 4 minutes 15 seconds.

**Claims**

1.  A vacuum sputtering apparatus for depositing a thin film of sputtered material on a substrate, the apparatus comprising:

   a vacuum chamber (2) for containing:

      a target (9) from which material is to be sputtered; and
      a substrate (12) upon which material from the target (9) is to be deposited;

   an ion gun (3) for projecting a beam of ions (8) towards the target (9), the ion gun (3) including:

      a plasma generation chamber (4) for generation of a plasma therein;
      gas admission means for admission to the plasma generation chamber (4) of a gas from which the plasma is to be generated;

r.f. coil means (6) for supplying r.f. power to gas in the plasma generation chamber (4) for generation of a plasma therefrom;

magnet means (7) for trapping adjacent the wall of the plasma generation chamber (4) electrons released as a result of plasma formation in the plasma generation chamber (4); and

extraction means (5) for extracting ions from the plasma in the plasma generation chamber (4) and for accelerating the extracted ions in a beam (8) arranged to impinge upon the target (9), the extraction means (5) including an accelerator grid (22);

r.f. power supply means (32) for supplying r.f. power to the r.f. coil (6);

d.c. voltage supply means (21) for supplying a d.c. voltage to the accelerator grid (22) to cause extraction of ions from the plasma generation chamber (4) and acceleration thereof in a beam (8) towards the target (9);

control signal generator means (23, 30; 23, 30, 38, 39, 40, 41) for deriving from the current flowing from the d.c. voltage supply means (21) to the accelerator grid (22) a control signal; and

a host computer system (31) which is arranged to be supplied with the control signal, to perform current/time integration and to control the operation of the r.f. power supply means (32),

the control signal generator means comprising:

resistance means (23) connected in series between the d.c. voltage supply (21) and the accelerator grid (22); and

differential amplifier means (30) whose input is connected across the resistance means (23) and whose output provides a control signal which is representative of the current flowing between the d.c. voltage supply (21) and the accelerator grid (22).

2. A vacuum sputtering apparatus according to Claim 1, in which the control signal generator means further comprises:

second resistance means (36) connected in series between a second d.c. voltage supply (25) and a second accelerator grid (27) of the ion gun (3); and

second differential amplifier means (37) whose input is connected across the second resistance means (36) and whose output provides a control signal which is representative of the current flowing between the second d.c. voltage supply (25) and the second accelerator grid (27) and which is also supplied to the host computer system (31).

3. A vacuum sputtering apparatus according to Claim 1, in which the control signal generator means additionally comprises voltage divider means (38, 39) for providing a voltage signal whose voltage is intermediate between the voltage of the d.c. voltage supply (21) and earth potential, amplifier means (40) for conditioning and amplifying the voltage signal from the voltage divider means (38, 39) whose output provides a signal representative of the accelerator grid voltage, and multiplier integrated circuit means (41) which receives as inputs the outputs from the differential amplifier means (30) and from the amplifier means (40) and whose output provides a control signal which is representative of the power supplied to the accelerator grid (22) and is supplied to the host computer means (31).

4. A vacuum sputtering apparatus according to Claim 3, in which the host computer system (31) is arranged to perform accelerator grid power/time integration and to control the operation of the r.f. power supply means (32).

5. A vacuum sputtering apparatus according to any one of Claims 1 to 4, further comprising:

shutter means (11) in the vacuum chamber (2) between the target (9) and the substrate (12) and movable between a first position in which the shutter means (11) shields the substrate (12) from material sputtered from the target (9) and a second position in which it permits material sputtered from the target (9) to reach the substrate (12), whereby with the shutter means (11) in its first position the parameters for the ion beam (8) can be established and verified, whereafter the d.c. power supply to the accelerator grid (22) can be turned off, and whereby with the shutter means (11) in its second position the d.c. power supply (21) to the accelerator grid (22) can be turned back on again to effect extraction of ions from the plasma generation chamber (4) to form an ion beam (8) and to cause material to be sputtered from the target (9) and to be deposited upon the substrate (12).

6. A vacuum sputtering apparatus according to any one of Claims 1 to 5, in which a surface of the target (9) is so positioned that the ion beam (8) impinges upon it at an oblique angle whereby material ejected from the target (9) travels along a path which is directed away from that of the ion beam (8).

7. A vacuum sputtering apparatus according to any one of Claims 1 to 6, in which the substrate (12) is so positioned that material ejected from the target (9) strikes it at an angle normal to the surface of the substrate (12) or at an angle which is oblique to the surface of the substrate (12).

8. A vacuum sputtering apparatus according to any one of Claims 1 to 7, in which the substrate (12) is mounted upon a rotatable substrate table (13).

9. A vacuum sputtering apparatus according to Claim 8, in which the substrate table (13) is arranged so as to be rotatable at a rotational speed of from about 5 rpm to about 1000 rpm.

10. A method of effecting vacuum sputtering of a material from a target (9) onto a substrate (12) in a vacuum chamber (2) so as to deposit a thin film of sputtered material on the substrate (12), which method comprises:

   providing an ion gun (3) for projecting a beam of ions (8) towards the target (9), the ion gun (3) including:

   a plasma generation chamber (4) for generation of a plasma therein;
   gas admission means for admission to the plasma generation chamber (4) of a gas from which the plasma is to be generated;
   r.f. coil means (6) for supplying r.f. power to gas in the plasma generation chamber (4) for generation of a plasma therefrom;
   magnet means (7) for trapping adjacent to the wall of the plasma generation chamber (4) electrons released as a result of plasma formation in the plasma generation chamber (4); and
   extraction means (5) for extracting ions from the plasma in the plasma generation chamber (4) and for accelerating the extracted ions in a beam (8) arranged to impinge upon the target (9), the extraction means (5) including an accelerator grid (22);

   supplying r.f. power to the r.f. coil (6) from an r.f. power supply means (32);
   supplying a d.c. voltage from a d.c. voltage supply means (21) to the accelerator grid (22) to cause extraction of ions from the plasma generation chamber (4) and acceleration thereof in a beam (8) towards the target (9);
   deriving from the current flowing from the d.c. voltage supply means (21) to the accelerator grid (22) a control signal;
   supplying the control signal to a host computer system (31) which is arranged to perform current/time integration and to control the operation of the r.f. power supply means (32);
   generating the control signal by means of a resistance means (23) connected in series between the d.c. voltage supply (21) and the accelerator grid (22) and a differential amplifier means (30) whose input is connected across the resistance means (23) and whose output provides a control signal which is representative of the current flowing between the d.c. voltage supply (21) and the accelerator grid (22).

11. A method according to Claim 10, in which the host computer system (31) is further supplied with an output signal from a differential amplifier means (37) whose input is connected across a second resistance means (36) connected in series between a second d.c. voltage supply (25) and a second accelerator grid (27) of the ion gun (3) and in which the control signal used to control the operation of the r.f. power supply means (32) is a function of the current flowing through the resistance means (23), of the current flowing through the second resistance means (36), and of time.

12. A method according to Claim 10, in which the control signal is generated by means of a resistance means (23) connected in series between the d.c. voltage supply (21) and the accelerator grid (22), differential amplifier means (30) whose input is connected across the resistance means (23) and whose output provides a control signal which is representative of the current flowing between the d.c. voltage supply (21) and the accelerator grid (22), voltage divider means (38, 39) for providing a voltage signal whose voltage is intermediate between the voltage of the d.c. voltage supply (21) and earth potential, amplifier means (40) for conditioning and amplifying the voltage signal from the voltage divider means (38, 39) whose output provides a signal representative of the accelerator grid voltage, and multiplier integrated circuit means (41) which receives as inputs the outputs from the differential amplifier means (30) and from the amplifier means (40) and whose output provides a control signal which is representative of the power supplied to the accelerator grid (22).

13. A method according to Claim 12, in which the host computer system (31) is arranged to perform accelerator grid power/time integration and to control the operation of the r.f. power supply means (32).

14. A method according to any one of Claims 10 to 13, in which a shutter means (11) is provided in the vacuum chamber (2) between the target (9) and the substrate (12) and is movable between a first position in which the shutter means (11) shields the substrate (12) from material sputtered from the target (9) and a second position in which it permits material sputtered from the target (9) to reach the substrate (12), in which the parameters for the ion beam (8) are established and verified with the shutter means (11) in its first position, in which the d.c. power supply to the accelerator grid (22) is then turned off and the shutter means (11) is moved to its second position, and in which the d.c. power supply (21) to the accelerator grid (22) is thereafter turned back on again to effect extraction of ions from the plasma generation chamber (4) to form an ion beam (8) and to cause material to be sputtered from the target (9) and to be deposited upon the substrate (12).

15. A method according to any one of Claims 10 to 14, in which a surface of the target (9) is so positioned that the ion beam (8) impinges upon it at an oblique angle whereby material ejected from the target (9) travels along a path which is directed away from that of the ion beam (8).

16. A method according to any one of Claims 10 to 15, in which the substrate (12) is so positioned that material ejected from the target (9) strikes it at an oblique angle.

17. A method according to any one of Claims 10 to 16, in which the substrate (12) is mounted upon a rotatable substrate table (13).

18. A method according to Claim 17, in which the substrate table (13) is arranged so as to be rotatable at a speed of from about 5 rpm up to about 1000 rpm.

**Patentansprüche**

1. Vakuumzerstäubungsapparatur zur Abscheidung eines dünnen Films zerstäubten Materials auf einem Substrat mit

   einer Vakuumkammer (2) zur Aufnahme

   eines Targets (9), von dem Material zerstäubt werden soll, und
   eines Substrats (12), auf dem Material aus dem Target (9) abgeschieden werden soll,

   einer Ionenkanone (3) zum Schießen eines Ionenstrahls (8) auf das Target (9), wobei die Ionenkanone (3) umfaßt

   eine Plasmaerzeugungskammer (4) zur Erzeugung eines Plasmas in ihr,
   Gaszuführungsmittel für die Zuführung eines Gases, aus dem das Plasma erzeugt werden soll, zu der Plasmaerzeugungskammer (4),
   HF-Spulenmittel (6) zur Zuführung von HF-Energie zu dem Gas in der Plasmaerzeugungskammer (4) zur Erzeugung eines Plasmas aus ihm,
   Magnetmittel (7) an der Wand der Plasmaerzeugungskammer (4) zum Einfangen von infolge Plasmabildung in der Plasmaerzeugungskammer (4) freigesetzten Elektronen und
   Ausschleusungsmittel (5) zum Ausschleusen von Ionen aus dem Plasma in der Plasmaerzeugungskammer (4) und zum Beschleunigen der ausgeschleusten Ionen in einem zum Auftreffen auf das Target (9) eingerichteten Strahl (8), wobei die Ausschleusungsmittel (5) ein Beschleunigungsgitter (22) enthalten,

   HF-Energieversorgungsmitteln (32) zur Zuführung von HF-Energie zu der HF-Spule (6),
   Gleichspannungsversorgungsmitteln (21) zur Zuführung einer Gleichspannung zu dem Beschleunigungsgitter (22) zur Ausschleusung von Ionen aus der Plasmaerzeugungskammer (4) und ihrer Beschleunigung in einem Strahl (8) auf das Target (9),
   Kontrollsignal-Generatormitteln (23,30;23,30,38,39,40,41) zur Ableitung eines Kontrollsignals aus dem Strom, der von den Gleichspannungsversorgungsmitteln (21) zu dem Beschleunigungsgitter (22) strömt, und
   einem Wirtsrechnersystem (31), das für die Versorgung mit dem Kontrollsignal eingerichtet ist, um eine Strom/ Zeit-Integration durchzuführen und den Betrieb der HF-Energieversorgungsmittel (32) zu kontrollieren, wobei die Kontrollsignal-Generatormittel

zwischen der Gleichspannungsversorgung (21) und dem Beschleunigungsgitter (22) in Reihe geschaltete Widerstandsmittel (23) und

Differentialverstärkermittel (30) umfassen, deren Eingang an das Widerstandsmittel (23) angeschlossen ist und deren Ausgang ein Kontrollsignal liefert, das für den zwischen der Gleichspannungsversorgung (21) und dem Beschleunigungsgitter (22) fließenden Strom repräsentativ ist.

2. Vakuumzerstäubungsapparatur nach Anspruch 1, bei der die Kontrollsignal-Generatormittel ferner umfassen:

zwischen einer zweiten Gleichspannungsversorgung (25) und einem zweiten Beschleunigungsgitter (27) der Ionenkanone (3) in Reihe geschaltete zweite Widerstandsmittel (36) und

zweite Differentialverstärkermittel (37), deren Eingang an die zweiten Widerstandsmittel (36) angeschlossen ist und deren Ausgang ein Kontrollsignal liefert, das für den zwischen der zweiten Gleichspannungsversorgung (25) und dem zweiten Beschleunigungsgitter (27) fließenden Strom repräsentativ ist und auch dem Wirtsrechnersystem (31) zugeführt wird.

3. Vakuumzerstäubungsapparatur nach Anspruch 1, bei der die Kontrollsignal-Generatormittel Spannungsteilermittel (38,39) zur Lieferung eines Spannungssignals, dessen Spannung in der Mitte zwischen der Spannung der Gleichspannungsversorgung (21) und dem Erdpotential liegt, Verstärkermittel (40) zur Konditionierung und Verstärkung des Spannungssignals von den Spannungsteilermitteln (38,39), deren Ausgang ein für die Beschleunigungsgitterspannung repräsentatives Signal liefert, und eine Schaltung (41) mit integriertem Vervielfacher umfassen, die als Eingang die Ausgänge von dem Differentialverstärkermittel (30) und von dem Verstärkermittel (40) empfängt und deren Ausgang ein Kontrollsignal liefert, das für die dem Beschleunigungsgitter (22) zugeführte Energie repräsentativ ist und dem Wirtsrechnermittel (31) zugeführt wird.

4. Vakuumzerstäubungsapparatur nach Anspruch 3, bei der das Wirtsrechnersystem (31) zur Durchführung einer Energie/Zeit-Integration des Beschleunigungsgitters und zur Kontrolle des Betriebs der HF-Energieversorgungsmittel (32) eingerichtet ist.

5. Vakuumzerstäubungsapparatur nach einem der Ansprüche 1 bis 4, ferner mit

Blendenmitteln (11) in der Vakuumkammer (2) zwischen dem Target (9) und dem Substrat (12), die zwischen einer ersten Position, in der die Blendenmittel (11) das Substrat (12) gegen aus dem Target (9) zerstäubtes Material abschirmen, und einer zweiten Position beweglich sind, in der sie dem aus dem Target (9) zerstäubtem Material ermöglichen, das Substrat (12) zu erreichen, wodurch in der ersten Position der Blendenmittel (11) die Parameter für den Ionenstrahl (8) eingestellt und überprüft werden können, worauf die Gleichstromversorgung für das Beschleunigungsgitter (22) abgeschaltet werden kann, und in der zweiten Position der Blendenmittel (11) die Gleichstromversorgung (21) für das Beschleunigungsgitter (22) wieder eingeschaltet werden kann, um die Ausschleusung von Ionen aus der Plasmaerzeugungskammer (4) zu bewirken, um einen Ionenstrahl (8) zu bilden und die Zerstäubung von Material aus dem Target (9) und seine Abscheidung auf dem Substrat (12) zu veranlassen.

6. Vakuumzerstäubungsapparatur nach einem der Ansprüche 1 bis 5, bei der eine Oberfläche des Targets (9) so positioniert ist, daß der Ionenstrahl (8) unter einem spitzen Winkel auf das Target auftrifft, wodurch das aus dem Target (9) herausgeschleuderte Material längs eines Weges wandert, der von dem des Ionenstrahls (8) weg gerichtet ist.

7. Vakuumzerstäubungsapparatur nach einem der Ansprüche 1 bis 6, bei der das Substrat (12) so positioniert ist, daß das aus dem Target (9) herausgeschleuderte Material normal oder schräg einfallend auf die Oberfläche des Substrats (12) auftrifft.

8. Vakuumzerstäubungsapparatur nach einem der Ansprüche 1 bis 7, bei der das Substrat (12) auf einem drehbaren Substrattisch (13) angebracht ist.

9. Vakuumzerstäubungsapparatur nach Anspruch 8, bei der der Substrattisch (13) so eingerichtet ist, daß er mit einer Drehzahl von etwa 5 UpM bis etwa 1000 UpM drehbar ist.

10. Verfahren der Vakuumzerstäubung eines Materials aus einem Target (9) auf ein Substrat (12) in einer Vakuumkammer (2) zur Abscheidung eines dünnen Films zerstäubten Materials auf dem Substrat (12), bei dem man

eine Ionenkanone (3) zum Schießen eines Ionenstrahls (8) auf das Target (9) vorsieht, wobei die Ionenkanone (3) umfaßt

eine Plasmaerzeugungskammer (4) zur Erzeugung eines Plasmas in ihr,

Gaszuführungsmittel für die Zuführung eines Gases, aus dem das Plasma erzeugt werden soll, zu der Plasmaerzeugungskammer (4),

HF-Spulenmittel (6) zur Zuführung von HF-Energie zu dem Gas in der Plasmaerzeugungskammer (4) zur Erzeugung eines Plasmas aus ihm,

Magnetmittel (7) an der Wand der Plasmaerzeugungskammer (4) zum Einfangen von infolge Plasmabildung in der Plasmaerzeugungskammer (4) freigesetzten Elektronen und

Ausschleusungsmittel (5) zum Ausschleusen von Ionen aus dem Plasma in der Plasmaerzeugungskammer (4) und zum Beschleunigen der ausgeschleusten Ionen in einem zum Auftreffen auf das Target (9) eingerichteten Strahl (8), wobei die Ausschleusungsmittel (5) ein Beschleunigungsgitter (22) enthalten,

aus einem HF-Energieversorgungsmittel (32) HF-Energie der HF-Spule zuführt,

aus einem Gleichspannungsversorgungsmittel (21) eine Gleichspannung dem Beschleunigungsgitter (22) zuführt zur Ausschleusung von Ionen aus der Plasmaerzeugungskammer (4) und ihrer Beschleunigung in einem Strahl (8) auf das Target (9),

ein Kontrollsignal aus dem Strom ableitet, der von dem Gleichspannungsversorgungsmittel (21) zu dem Beschleunigungsgitter (22) strömt,

das Kontrollsignal einem Wirtsrechnersystem (31) zuführt, das zur Durchführung einer Strom/Zeit-Integration und zur Kontrolle des Betriebs der HF-Energieversorgungsmittel (32) eingerichtet ist und

das Kontrollsignal durch zwischen der Gleichspannungsversorgung (21) und dem Beschleunigungsgitter (22) in Reihe geschaltete Widerstandsmittel (23) und Differentialverstärkermittel (30) erzeugt, deren Eingang an das Widerstandsmittel (23) angeschlossen ist und deren Ausgang ein Kontrollsignal liefert, das für den zwischen der Gleichspannungsversorgung (21) und dem Beschleunigungsgitter (22) fließenden Strom repräsentativ ist.

**11.** Verfahren nach Anspruch 10, bei dem das Wirtsrechnersystem (31) ferner mit einem Ausgangssignal aus einem Differentialverstärkermittel (37) versorgt wird, dessen Eingang an ein zwischen einer zweiten Gleichspannungsversorgung (25) und einem zweiten Beschleunigungsgitter (27) der Ionenkanone (3) in Reihe geschaltetes zweites Widerstandsmittel (36) angeschlossen ist, und bei dem das zur Kontrolle des Betriebs der HF-Energieversorgungsmittel (32) dienende Kontrollsignal eine Funktion des durch das Widerstandsmittel (23) fließenden Stroms, des durch das zweite Widerstandsmittel (36) fließenden Stroms und der Zeit ist.

**12.** Verfahren nach Anspruch 10, bei dem das Kontrollsignal erzeugt wird mittels eines zwischen der Gleichspannungsversorgung (21) und dem Beschleunigungsgitter (22) in Reihe geschalteten Widerstandsmittels (23), eines Differentialverstärkermittels (30), dessen Eingang an das Widerstandsmittel (23) angeschlossen ist und dessen Ausgang ein Kontrollsignal liefert, das für den zwischen der Gleichspannungsversorgung (21) und dem Beschleunigungsgitter (22) fließenden Strom repräsentativ ist, Spannungsteilermitteln (38,39) zur Lieferung eines Spannungssignals, dessen Spannung in der Mitte zwischen der Spannung der Gleichspannungsversorgung (21) und dem Erdpotential liegt, Verstärkermitteln (40) zur Konditionierung und Verstärkung des Spannungssignals von den Spannungsteilermitteln (38,39), deren Ausgang ein für die Beschleunigungsgitterspannung repräsentatives Signal liefert, und einer Schaltung (41) mit integriertem Vervielfacher, die als Eingang die Ausgänge von dem Differentialverstärkermittel (30) und von dem Verstärkermittel (40) empfängt und deren Ausgang ein Kontrollsignal liefert, das für die dem Beschleunigungsgitter (22) zugeführte Energie repräsentativ ist.

**13.** Verfahren nach Anspruch 12, bei dem das Wirtsrechnersystem (31) zur Durchführung einer Energie/Zeit-Integration des Beschleunigungsgitters und zur Kontrolle des Betriebs des HF-Energieversorgungsmittels (32) eingerichtet ist.

**14.** Verfahren nach einem der Ansprüche 10 bis 13, bei dem

Blendenmittel (11) in der Vakuumkammer (2) zwischen dem Target (9) und dem Substrat (12) vorgesehen und zwischen einer ersten Position, in der die Blendenmittel (11) das Substrat (12) gegen aus dem Target (9) zerstäubtes Material abschirmen, und einer zweiten Position beweglich sind, in der sie dem aus dem Target (9) zerstäubtem Material ermöglichen, das Substrat (12) zu erreichen, bei dem in der ersten Position der Blendenmittel (11) die Parameter für den Ionenstrahl (8) eingestellt und überprüft werden, bei dem die Gleichstromversorgung für das Beschleunigungsgitter (22) dann abgeschaltet wird und die Blendenmittel (11) in ihre zweite Position bewegt werden und bei dem die Gleichstromversorgung (21) für das Beschleunigungsgitter (22) dann zur Ausschleusung von Ionen aus der Plasmaerzeugungskammer (4) wieder eingeschaltet wird, um einen Ionenstrahl (8) zu bilden und die Zerstäubung von Material aus dem Target (9) und seine Abscheidung auf dem Substrat (12) zu veranlassen.

15. Verfahren nach einem der Ansprüche 10 bis 14, bei dem eine Oberfläche des Targets (9) so positioniert ist, daß der Ionenstrahl (8) unter einem spitzen Winkel auf das Target auftrifft, wodurch das aus dem Target (9) herausgeschleuderte Material längs eines Weges wandert, der von dem des Ionenstrahls (8) weg gerichtet ist.

16. Verfahren nach einem der Ansprüche 10 bis 15, bei dem das Substrat (12) so positioniert ist, daß das aus dem Target (9) herausgeschleuderte Material unter einem schrägen Winkel auftrifft.

17. Verfahren nach einem der Ansprüche 10 bis 16, bei dem das Substrat (12) auf einem drehbaren Substrattisch (13) angebracht ist.

18. Verfahren nach Anspruch 17, bei dem der Substrattisch (13) so eingerichtet ist, daß er mit einer Drehzahl von etwa 5 UpM bis etwa 1000 UpM drehbar ist.


**Revendications**

1. Appareil de pulvérisation cathodique sous vide pour déposer un film mince de matériau pulvérisé de manière cathodique sur un substrat, l'appareil comprenant:

    une chambre sous vide (2) destinée à contenir :

        une cible (9) à partir de laquelle le matériau est destiné à être pulvérisé de manière cathodique ; et
        un substrat (12) sur lequel le matériau de la cible (9) est destiné à être déposé ;

    un canon ionique (3) pour projeter un faisceau d'ions (8) vers la cible (9), le canon ionique (3) comprenant :

        une chambre de génération de plasma (4) pour la génération d'un plasma à l'intérieur de celle-ci;
        un moyen d'admission de gaz pour admission dans la chambre de génération de plasma (4) d'un gaz à partir duquel le plasma doit être généré ;
        un moyen de bobine de radiofréquence (6) pour alimenter en puissance de radiofréquence un gaz dans la chambre de génération de plasma (4) pour la génération d'un plasma à partir de celui-ci;
        un moyen d'aimant (7) destiné à piéger de manière adjacente à la paroi de la chambre de génération de plasma (4) des électrons libérés en conséquence de la formation du plasma dans la chambre de génération de plasma (4) ; et
        un moyen d'extraction (5) destiné à extraire des ions à partir du plasma dans la chambre de génération de plasma (4) et à accélérer les ions extraits en un faisceau (8) agencé pour frapper la cible (9), le moyen d'extraction (5) comprenant une grille d'accélérateur (22) ;

    un moyen d'alimentation en puissance radiofréquence (32) destiné à fournir une puissance radiofréquence à la bobine de radiofréquence (6) ;
    un moyen d'alimentation en tension de courant continu (21) destiné à fournir une tension de courant continu à la grille d'accélérateur (22) pour provoquer l'extraction d'ions à partir de la chambre de génération de plasma (4) et leur accélération en un faisceau (8) vers la cible (9) ;
    un moyen de générateur de signal de commande (23, 30 ; 23, 30, 38, 39, 40, 41) destiné à dériver un signal de commande à partir du courant sortant du moyen d'alimentation en tension de courant continu (21) à la grille d'accélérateur (22) ; et
    un système informatisé hôte (31) qui est agencé pour être alimenté avec le signal de commande, pour réaliser une intégration courant/temps et pour commander le fonctionnement du moyen d'alimentation en puissance de radiofréquence (32),
    le moyen de générateur du signal de commande comprenant :

        un moyen de résistance (23) connecté en série entre l'alimentation en tension de courant continu (21) et la grille d'accélérateur (22) ; et
        un moyen d'amplificateur différentiel (30) dont l'entrée est connectée à travers le moyen de résistance (23) et dont la sortie délivre un signal de commande qui est représentatif du courant circulant entre l'alimentation en tension de courant continu (21) et la grille d'accélérateur (22).

2. Appareil de pulvérisation cathodique sous vide selon la revendication 1, dans lequel le moyen de générateur de signal de commande comprend en outre :

un second moyen de résistance (36) connecté en série entre une seconde alimentation en tension de courant continu (25) et une seconde grille d'accélérateur (27) du canon ionique (3) ; et
un second moyen d'amplificateur différentiel (37) dont l'entrée est connectée à travers le second moyen de résistance (36) et dont la sortie délivre un signal de commande qui est représentatif du courant circulant entre la seconde alimentation en tension de courant continu (25) et la seconde grille d'accélérateur (27) et qui est également fourni au système informatisé hôte (31).

3. Appareil de pulvérisation cathodique sous vide selon la revendication 1, dans lequel le moyen de générateur de signal de commande comprend additionnellement un moyen de diviseur de tension (38, 39) destiné à délivrer un signal de tension dont la tension est intermédiaire entre la tension de l'alimentation en tension de courant continu (21) et le potentiel de la masse, un moyen d'amplificateur (40) destiné à conditionner et à amplifier le signal de tension en provenance du moyen de diviseur de tension (38, 39) dont la sortie délivre un signal représentatif de la tension de grille d'accélérateur, et un moyen de circuit intégré de multiplicateur (41) qui reçoit en entrée les sorties du moyen d'amplificateur différentiel (30) et du moyen d'amplificateur (40) et dont la sortie délivre un signal de commande qui est représentatif de la puissance délivrée à la grille d'accélérateur (22) et est fourni au moyen informatisé hôte (31).

4. Appareil de pulvérisation cathodique sous vide selon la revendication 3, dans lequel le système informatisé hôte (31) est agencé pour réaliser une intégration puissance de grille d'accélérateur/temps et pour commander le fonctionnement du moyen d'alimentation en puissance de radiofréquence (32).

5. Appareil de pulvérisation cathodique sous vide selon l'une quelconque des revendications 1 à 4, comprenant en outre :

un moyen d'obturateur (11) dans la chambre sous vide (2) entre la cible (9) et le substrat (12) et mobile entre une première position dans laquelle le moyen d'obturateur (11) masque le substrat (12) par rapport au matériau pulvérisé de la cible (9) et une seconde position dans laquelle il permet au matériau pulvérisé de la cible (9) d'atteindre le substrat (12), moyennant quoi, le moyen d'obturateur (11) se trouvant dans sa première position, les paramètres pour le faisceau d'ions (8) peuvent être établis et vérifiés, après quoi l'alimentation en puissance de courant continu à la grille d'accélérateur (22) peut être interrompue, et moyennant quoi, le moyen d'obturateur (11) se trouvant dans sa seconde position, l'alimentation en puissance de courant continu (21) à la grille d'accélérateur (22) peut être remise en marche pour exécuter l'extraction d'ions à partir de la chambre de génération de plasma (4) pour former un faisceau d'ions (8) et pour faire en sorte que le matériau soit pulvérisé de manière cathodique à partir de la cible (9) et soit déposé sur le substrat (12).

6. Appareil de pulvérisation cathodique sous vide selon l'une quelconque des revendications 1 à 5, dans lequel une surface de la cible (9) doit être positionnée de sorte que le faisceau d'ions (8) la frappe à un angle oblique, moyennant quoi le matériau éjecté de la cible (9) se déplace sur un chemin qui est dirigé à distance d'un chemin du faisceau d'ions (8).

7. Appareil de pulvérisation cathodique sous vide selon l'une quelconque des revendications 1 à 6, dans lequel le substrat (12) est positionné de telle sorte que le matériau éjecté de la cible (9) le frappe à un angle normal à la surface du substrat (12) ou à un angle qui est oblique par rapport à la surface du substrat (12).

8. Appareil de pulvérisation cathodique sous vide selon l'une quelconque des revendications 1 à 7, dans lequel le substrat (12) est monté sur une table de substrat rotative (13).

9. Appareil de pulvérisation cathodique sous vide selon la revendication 8, dans lequel la table de substrat (13) est agencée de manière à pouvoir tourner à une vitesse de rotation d'environ 5 tr/min à environ 1 000 tr/min.

10. Procédé d'exécution de pulvérisation cathodique sous vide d'un matériau à partir d'une cible (9) sur un substrat (12) dans une chambre sous vide (2) de façon à déposer un film mince de matériau pulvérisé de manière cathodique sur le substrat (12), lequel procédé comprend les étapes consistant à :

fournir un canon ionique (3) pour projeter un faisceau d'ions (8) vers la cible (9), le canon ionique comprenant :

une chambre de génération de plasma (4) pour la génération d'un plasma à l'intérieur de celle-ci ;
un moyen d'admission de gaz pour admission dans la chambre de génération de plasma (4) d'un gaz à partir duquel le plasma doit être généré ;
un moyen de bobine de radiofréquence (6) pour alimenter en puissance de radiofréquence un gaz dans la chambre de génération de plasma (4) pour la génération d'un plasma à partir de celui-ci ;
un moyen d'aimant (7) pour piéger de manière adjacente à la paroi de la chambre de génération de plasma (4) des électrons libérés en conséquence de la formation du plasma dans la chambre de génération de plasma (4) ; et
un moyen d'extraction (5) pour extraire des ions à partir du plasma dans la chambre de génération de plasma (4) et pour accélérer les ions extraits en un faisceau (8) agencé pour frapper la cible (9), le moyen d'extraction (5) comprenant une grille d'accélérateur (22) ;

alimenter en puissance de radiofréquence la bobine de radiofréquence (6) à partir d'un moyen d'alimentation en puissance de radiofréquence (32) ;
alimenter la grille d'accélérateur (22) en tension de courant continu à partir d'un moyen d'alimentation en tension de courant continu (21), pour provoquer l'extraction d'ions à partir de la chambre de génération de plasma (4) et leur accélération en un faisceau (8) vers la cible (9);
dériver un signal de commande à partir du courant sortant du moyen d'alimentation en tension de courant continu (21) à la grille d'accélérateur (22) ;
délivrer le signal de commande à un système informatisé hôte (31) qui est agencé pour exécuter une intégration courant/temps et pour commander le fonctionnement du moyen d'alimentation en puissance de radiofréquence (32) ;
générer le signal de commande au moyen d'un moyen de résistance (23) connecté en série entre l'alimentation en tension de courant continu (21) et la grille d'accélérateur (22) et d'un moyen d'amplificateur différentiel (30) dont l'entrée est connectée à travers le moyen de résistance (23) et dont la sortie délivre un signal de commande qui est représentatif du courant circulant entre l'alimentation en tension de courant continu (21) et la grille d'accélérateur (22).

11. Procédé selon la revendication 10, dans lequel le système informatisé hôte (31) est en outre alimenté avec un signal de sortie provenant d'un moyen d'amplificateur différentiel (37) dont l'entrée est connectée à travers un second moyen de résistance (36) connecté en série entre une seconde alimentation en tension de courant continu (25) et une seconde grille d'accélérateur (27) du canon ionique (3) et dans lequel le signal de commande utilisé pour commander le fonctionnement du moyen d'alimentation en puissance de radiofréquence (32) est une fonction du courant circulant à travers le moyen de résistance (23), du courant circulant à travers le second moyen de résistance (36), et du temps.

12. Procédé selon la revendication 10, dans lequel le signal de commande est généré au moyen d'un moyen de résistance (23) connecté en série entre l'alimentation en tension de courant continu (21) et la grille d'accélérateur (22), du moyen d'amplificateur différentiel (30) dont l'entrée est connectée à travers le moyen de résistance (23) et dont la sortie délivre un signal de commande qui est représentatif du courant circulant entre l'alimentation en tension de courant continu (21) et la grille d'accélérateur (22), d'un moyen de diviseur de tension (38, 39) pour délivrer un signal de tension dont la tension est intermédiaire entre la tension de l'alimentation en tension de courant continu (21) et le potentiel de la masse, d'un moyen d'amplificateur (40) pour conditionner et amplifier le signal de tension à partir du moyen de diviseur de tension (38, 39) dont la sortie délivre un signal représentatif de la tension de grille d'accélérateur et un moyen de circuit intégré de multiplicateur (41) qui reçoit en entrée les sorties du moyen d'amplificateur différentiel (30) et du moyen d'amplificateur (40) et dont la sortie délivre un signal de commande qui est représentatif de la puissance fournie à la grille d'accélérateur (22).

13. Procédé selon la revendication 12, dans lequel le système informatisé hôte (31) est agencé pour réaliser l'intégration puissance de grille d'accélérateur/temps et pour commander le fonctionnement du moyen d'alimentation en puissance de radiofréquence (32).

14. Procédé selon l'une quelconque des revendications 10 à 13, dans lequel un moyen d'obturateur (11) est disposé dans la chambre sous vide (2) entre la cible (9) et le substrat (12) et est mobile entre une première position dans laquelle le moyen d'obturateur (11) masque le substrat (12) par rapport au matériau pulvérisé de la cible (9) et une seconde position dans laquelle il permet au matériau pulvérisé de la cible (9) d'atteindre le substrat (12), dans lequel les paramètres pour le faisceau d'ions (8) sont établis et vérifiés, le moyen d'obturateur (11) se trouvant dans sa première position, dans lequel l'alimentation en puissance de courant continu à la grille d'accélérateur (22) est interrompue et le moyen d'obturateur (11) est amené à sa seconde position, et dans lequel l'alimentation en puissance de courant continu (21) à la grille d'accélérateur (22) est par la suite remise en marche pour exécuter l'extraction d'ions à partir de la chambre de génération de plasma (4) pour former un faisceau d'ions (8) et pour faire en sorte que le matériau soit pulvérisé à partir de la cible (9) et soit déposé sur le substrat (12).

15. Procédé selon l'une quelconque des revendications 10 à 14, dans lequel une surface de la cible (9) est positionnée de sorte que le faisceau d'ions (8) la frappe à un angle oblique moyennant quoi le matériau éjecté à partir de la cible (9) se déplace sur un chemin qui est dirigé à distance d'un chemin du faisceau d'ions (8).

16. Procédé selon l'une quelconque des revendications 10 à 15, dans lequel le substrat (12) est positionné de telle sorte que le matériau éjecté à partir de la cible (9) le frappe à un angle oblique.

17. Procédé selon l'une quelconque des revendications 10 à 16, dans lequel le substrat (12) est monté sur une table de substrat rotative (13).

18. Procédé selon la revendication 17, dans lequel la table de substrat (13) est agencée de manière à pouvoir tourner à une vitesse d'environ 5 tr/min jusqu'à environ 1 000 tr/min.

**FIG.1.**

**FIG.2.**

FIG.3.

FIG.4.

**FIG.5.**

**FIG.6.**